# EUROPEAN PATENT APPLICATION

(11) **EP 1 793 361 A2**
(43) Date of publication of application: **06.06.2007**
(21) Application number: 06256139.4
(22) Date of filing: 30.11.2006
(51) Int. Cl.: G09G 3/28

(54) **Plasma display apparatus**

(30) Priority: 30.11.2005 KR 20050115177
(71) Applicant: LG Electronics Inc., Seoul 150-721 (KR)
(72) Inventor: Choi, Jeong Pil LG Village Apt.408-1103, Suwon-si, Gyeonggi-do (KR); Kong, Bung Goo Sanghyeon Maeul Hyundai 5-cha, Yongin-si, Gyeonggi-do (KR)
(74) Representative: Camp, Ronald

(57) **Abstract**

A plasma display apparatus comprises a Plasma Display Panel (PDP) (400) comprising sustain electrodes (Z) commonly connected through a conductive connection pad (700), two or more Z sustain boards (480a, 480b) for driving the sustain electrodes, and a current communication unit (690) for electrically connecting the Z sustain boards and communicating current between the Z sustain boards.

The Y electrodes may be divided with two or more groups, each group having a respective common conductive pad.

## Description

The present invention relates to a plasma display apparatus

In general, a Plasma Display Panel (hereinafter, referred to as "PDP") is adapted to display an image including characters and/or graphics by exciting phosphors with ultraviolet radiation of 147nm, which is generated at the time of discharge of an inert gas mixture of He+Xe or Ne+Xe.

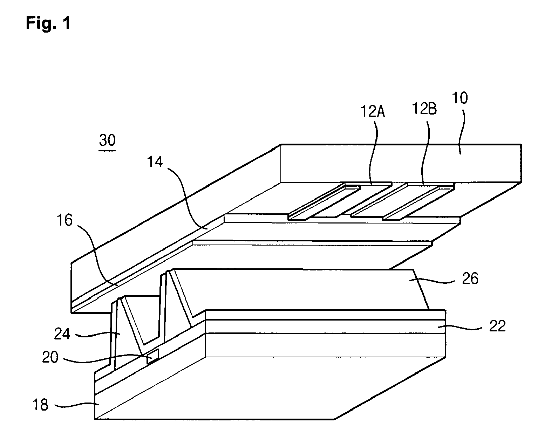

FIG. 1 is an enlarged view of a discharge cell of a conventional AC type PDP. A discharge cell 30 illustrated in FIG. 1 comprises a front plate and a rear plate. The front plate has a sustain electrode pair 12A and 12B, an upper dielectric layer 14 and a protection layer 16, all of which are sequentially formed over a front substrate 10. The rear plate has a data electrode 20, a lower dielectric layer 22, barrier ribs 24 and a phosphor layer 26, all of which are sequentially formed over a rear substrate 18.

Each of the sustain electrode pair 12A and 12B consists of a transparent electrode, and a metal electrode for compensating for high resistance of the transparent electrode. The sustain electrode pair 12A and 12B are divided into a scan electrode 12A and a sustain electrode 12B. The scan electrode 12A mainly supplies a scan signal for address discharge and a sustain sign for sustain discharge, and the sustain electrode 12B mainly supplies a sustain signal.

The data electrode 20 is formed to cross the sustain electrode pair 12A and 12B. The data electrode 20 supplies a data signal for address discharge. Charges generated by discharge accumulate on the upper dielectric layer 14 and the lower dielectric layer 22. The protection layer 16 serves to prevent damage to the upper dielectric layer 14 due to sputtering at the time of discharge, and also to increase emission efficiency of secondary electrons. The dielectric layers 14 and 22, and the protection layer 16 serve to allow an externally applied discharge voltage to be lowered.

The barrier ribs 24 provide discharge spaces together with the front and rear substrates 10 and 18. The barrier ribs 24 are formed parallel to the data electrode 20, and serve to prevent ultraviolet radiation, which is generated at the time of gas discharge, from leaking to neighboring cells. The phosphor layer 26 is coated on surfaces of the lower dielectric layer 22 and the barrier ribs 24, and generate red, green or blue visible light. The discharge space is filled with an inert gas, such as He, Ne, Ar, Xe or Kr, for gas discharge, a discharge gas in which the inert gases are combined, or excimer gas capable of generated ultraviolet radiation through discharge. The discharge cell 30 constructed above is selected as an opposite discharge by the data electrode 20 and the scan electrode 12A, and maintains discharge by surface discharge by means of the sustain electrode pair 12A and 12B.

Accordingly, as the phosphor layer 26 is excited with ultraviolet radiation generated at the time of sustain discharge, visible light is emitted from the discharge cell 30. In this case, the discharge cell 30 implements gray levels necessary for image display by controlling a sustain discharge period, that is, the number of sustain discharges according to video data. Three discharge cells respectively coated with red, green and blue phosphors 26 are combined to implement a color of one pixel.

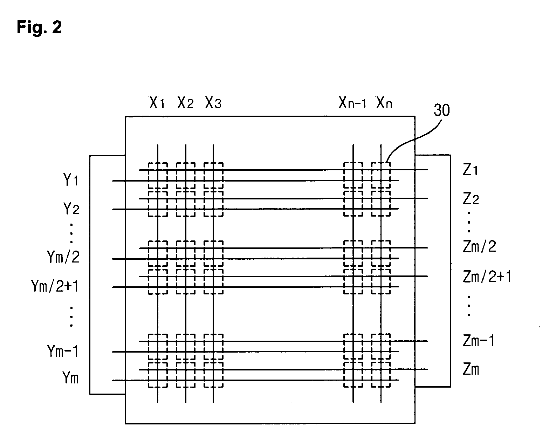

FIG. 2 is a view illustrating an overall form of electrode arrangements of a PDP including the discharge cell illustrated in FIG. 1. It can be seen from FIG. 2 that a plurality of the discharge cells 30 are formed at respective intersections of scan electrode lines Y1 to Ym, sustain electrode lines Z1 to Zm, and data electrode lines X1 to Xn. The scan electrode lines Y1 to Ym supply a scan pulse and a sustain pulse so that the discharge cells 30 can be scanned on a line basis and discharge can be sustained in the discharge cells 30. The sustain electrode lines Z1 to Zm commonly supply a sustain pulse so that discharge can be sustained in the discharge cells 30 along with the scan electrode lines Y1 to Ym. The data electrode lines X1 to Xn supply a data pulse, which is synchronized with the scan pulse, on a line basis so that the discharge cells 30 whose discharge will be sustained according to a logic value of the data pulse can be selected.

A representative driving method of the PDP constructed above includes an Address and Display Separation (ADS) driving method in which driving is carried out with a period being divided into an address period and a display period (that is, a sustain period). In the ADS driving method, one frame is divided into a number of subfields corresponding to respective bits of a video data, and the subfields are divided into a reset period, an address period and a sustain period again. In each of the subfields, the same weight is applied to the reset period RPD and the address period APD, but different weights are applied to the sustain period SPD. Accordingly, the PDP represents gray levels corresponding to a video data through a combination of the sustain periods in which discharge is sustained according to a video data.

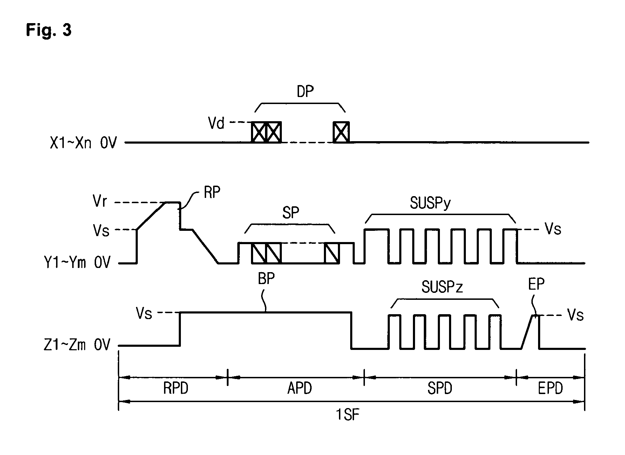

FIG. 3 is a view illustrating a general driving waveform supplied to the PDP illustrated in FIG. 2 in one subfield of a number of subfields.

As illustrated in FIG. 3, in the PDP, after the complete lighting discharge has been generated, wall charges are erased in the reset period RPD, using a reset pulse to reset all the discharge cells 30 to an off state in which wall charge remains. To this end, to the scan electrode lines Y1 to Ym are supplied a ramp-up pulse gradually rising from a step voltage Vs to a peak voltage Vr, and a ramp-down pulse gradually falling from the step voltage Vs to a ground voltage 0V, as a reset pulse RP. A first dark discharge is generated in all discharge cells 30 by means of the ramp-up pulse. A second dark discharge is then generated in all discharge cells 30 by means of the ramp-down pulse and a bias pulse BP supplied to the sustain electrode lines Z1 to Zm. Thereafter, as the wall charges formed in response to the voltages in the scan electrode lines Y1 to Ym and the sustain electrode lines Z1 to Zm decrease in response to the ramp-down pulse, all discharge cells 30 become reset to an off state in which wall charge remains. In the reset period RPD, the voltage of the data electrode lines X1 to Xn is clamped to the ground voltage 0V.

In an address period APD, a scan pulse SP is supplied to the scan electrode lines Y1 to Ym on a line basis, and a data pulse DP is selectively supplied to each of the data electrode lines X1 to Xn in synchronization with the scan pulse SP. Thus, an address discharge is generated in discharge cells to which the data pulse DP and the scan pulse SP have been supplied, so that the discharge cells are set to an on state where sufficient wall charge for a subsequent sustain discharge is formed. However, an address discharge is not generated in discharge cells to which the data pulse DP and the scan pulse SP have not been supplied, so that those discharge cells remain in an off state.

In a sustain period SPD, Y and Z sustain pulses SUSPy and SUSPz are alternately supplied to the scan electrode lines Y1 to Ym and the sustain electrode lines Z1 to Zm, so that the state of a discharge cell which was determined in the address period APD is sustained. In more detail, discharge cells in an on state where wall charge has been sufficiently formed in the address period APD are kept in the on state by means of discharge by the Y and Z sustain pulses SUSPy and SUSPz, and discharge cells in an off state are kept in the off state without discharge. In an erase period EPD subsequent to the sustain period SPD, an erase pulse EP is supplied to the sustain electrode lines Z1 to Zm to generate an erase discharge, thereby erasing wall charges existing in all discharge cells 30.

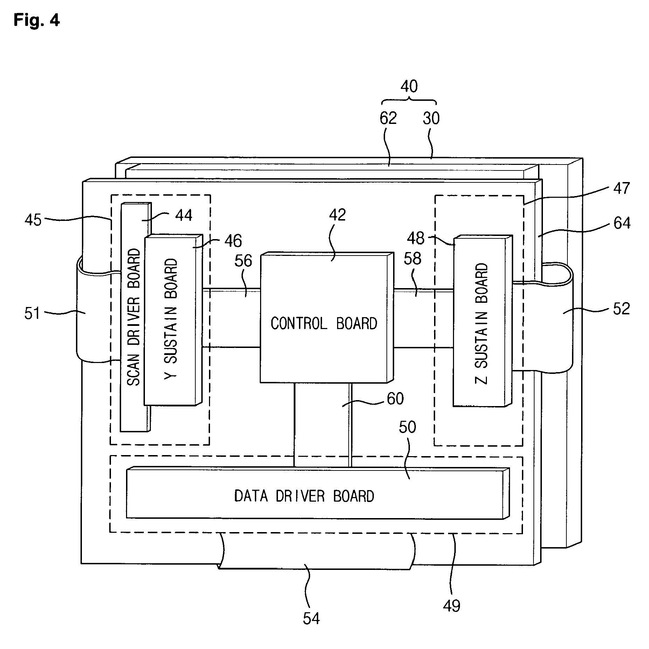

As illustrated in FIG. 4, a conventional plasma display apparatus comprises a scan driver 45 for driving the scan electrode lines Y1 to Ym of a PDP 40, a sustain driver 47 for driving the sustain electrode lines Z1 to Zm, a data driver 49 for driving the data electrode lines X1 to Xm, a control board 42 for controlling the scan driver 45, the sustain driver 47 and the data driver 49, and a power supply board (not shown) for supplying power to each of the scan driver 45, the sustain driver 47, the data driver 49 and the control board 42.

The scan driver 45 comprises a scan driver board 44 for generating the reset pulse RP and the scan pulse SP illustrated in FIG. 3, and a Y sustain board 46 for generating the Y sustain pulse SUSPy. The scan driver board 44 supplies the scan pulse SP to the scan electrode lines Y1 to Ym of the PDP 40 via a Y Flexible Printed Circuit (FPC) 51. The Y sustain board 46 supplies the Y sustain pulse SUSPy to the scan electrode lines Y1 to Ym via the scan driver board 44 and the Y FPC 51.

The sustain driver 47 comprises a Z sustain board 48 for generating the bias pulse BP and the Z sustain pulse SUSPz illustrated in FIG. 3. The Z sustain board supplies the bias pulse BP and the Z sustain pulse SUSPz to the sustain electrode lines Z1 to Zm of the PDP 40 via a Z FPC 52.

The data driver 49 comprises a data driver board 50 for generating the data pulse DP illustrated in FIG. 3. The data driver board 50 supplies the data pulse DP to the data electrode lines X1 to Xn of the PDP 40 via an X FPC 54.

The control board 42 generates X, Y and Z timing control signals of the scan, sustain and data drivers 45, 47 and 49. The control board 42 supplies the Y timing control signal to the scan driver 45 via the first FPC 56, the Z timing control signal to the sustain driver 47 via the second FPC 58, and the X timing control signal to the data driver 49 via the third FPC 60, respectively.

Meanwhile, recently, as the demand for high-resolution products increases, large-sized PDP products implementing Full HD (1920*1080) resolutions have been developed. The large size trend of the PDP has a problem in that though a large size of a Printed Circuit Board (PCB) forming the driving boards shown in FIG. 4 is required, it is difficult to drive the PDP using a single large-sized PCB in view of the manufacture cost and driving stability. Accordingly, it is necessary to divide the driving boards in order to drive the large size PDP. However, such dividing of the driving boards causes several problems due to differences between the respective operating characteristics of various driving elements mounted in the driving boards.

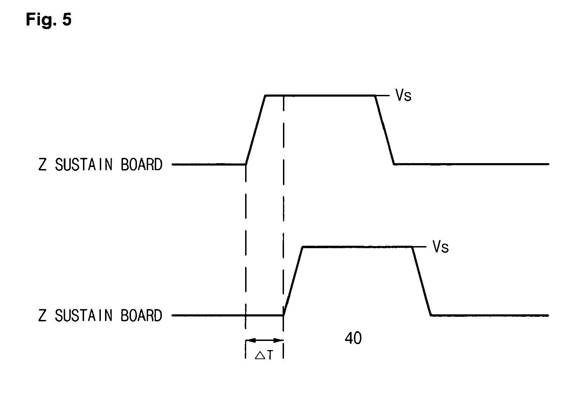

As illustrated in FIG. 5, dividing the Z sustain board causes a deviation ΔT in terms of timing between the sustain pulses output to the sustain electrodes due to differences between the operating characteristics of various switching elements, etc., which are mounted in each Z sustain board.

This driving difference between the sustain pulses can cause the generation of heat due to deviation in the current flowing into a commonly connected part of the sustain electrodes. Consequently, a problem can arise because the sustain electrodes may become damaged.

Accordingly, embodiments of the invention can provide a plasma display apparatus, which can allow the manufacturing cost associated with a large size of a PDP to be reduced and which can prevent damage to electrodes, by providing improved driving boards for the plasma display apparatus.

In accordance with a first aspect of the invention a plasma display apparatus comprises a PDP comprising sustain electrodes commonly connected through a conductive connection pad, two or more Z sustain boards arranged to drive the sustain electrodes, and a current communication unit arranged to electrically connect the Z sustain boards and to communicate current between the Z sustain boards.

The current communication unit may comprise a deviation current communication unit arranged to communicate current depending on driving differences between the Z sustain boards.

The current communication unit may have a resistance value smaller than that of the connection pad.

The current communication unit may comprise any one of a PCD, a FPC and conductive metal.

The current communication unit may electrically connect output terminals of the Z sustain boards.

The PDP may have a size of at least 70 inches.

In accordance with another aspect of the invention a plasma display apparatus comprises a PDP comprising sustain electrodes divided into two or more electrode groups and connected through a conductive connection pad on a electrode-group basis, Z sustain boards arranged to drive the respective electrode groups, and a current communication unit arranged to electrically connect the Z sustain boards and to communicate current between the Z sustain boards.

The current communication unit may comprise a deviation current communication unit arranged to communicate current depending on driving differences between the Z sustain boards.

The current communication unit may have a resistance value smaller than that of the connection pad.

The current communication unit may comprise any one of a PCD, a FPC and conductive metal.

The current communication unit may electrically connect output terminals of the Z sustain boards.

The PDP may have a size of at least 70 inches.

Embodiments of the invention will now be described by way of non-limiting example only, with reference to the drawings, in which like numerals refer to like elements.

FIG. 1 is an enlarged view of one of a plurality of discharge cells constituting a conventional AC type PDP;

FIG. 2 is a view illustrating an overall form of electrode arrangements of a PDP including the discharge cell illustrated in FIG. 1;

FIG. 3 is a view illustrating a general driving waveform supplied to the PDP illustrated in FIG. 2 in one subfield of a number of subfields;

FIG. 4 is a view illustrating a conventional plasma display apparatus;

FIG. 5 is a view illustrating driving deviation of a sustain pulse arising from the division of a Z sustain board;

FIG. 6 is a view illustrating a plasma display apparatus according to an embodiment of the invention;

FIG. 7 is a view schematically illustrating the plasma display apparatus of FIG. 6, which is coupled to one structure of the sustain electrode; and

FIG. 8 is a view schematically illustrating the plasma display apparatus of FIG. 6, which is coupled to another structure of the sustain electrode.

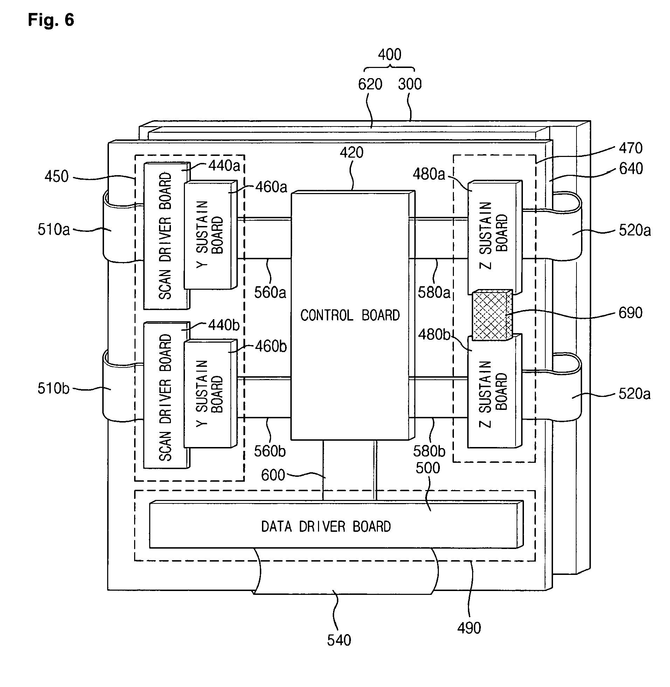

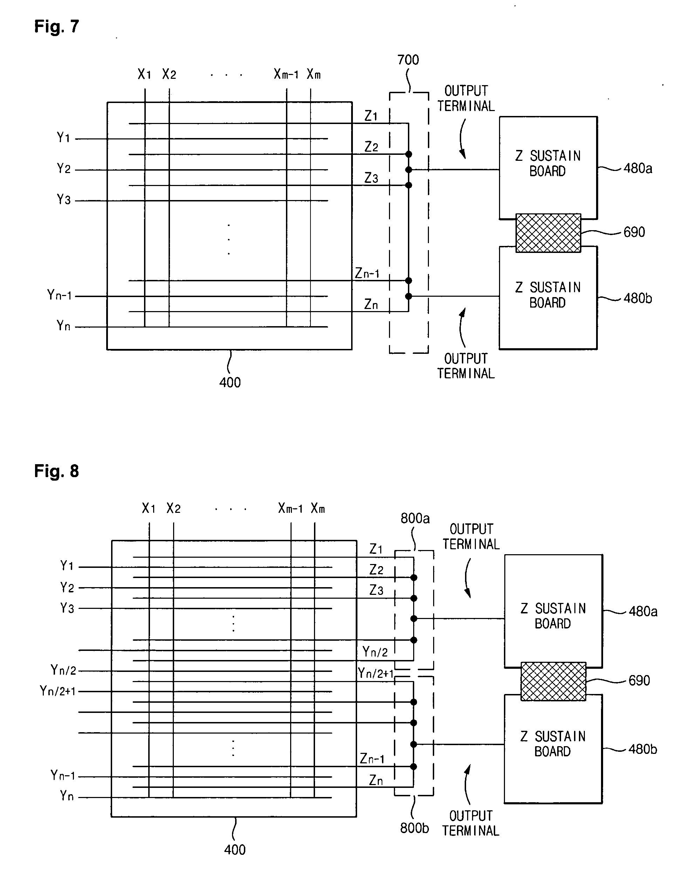

As illustrated in FIGS. 6 and 7, a plasma display apparatus comprises a PDP 400 having scan electrodes Y1 to Yn, data electrodes X1 to Xm, and sustain electrodes Z1 to Zn commonly connected by a conductive connection pad 700, a scan driver 450 for driving the scan electrodes Y1 to Yn, a sustain driver 470 comprising two or more Z sustain boards 480a and 480b for driving the sustain electrodes Z1 to Zn, a data driver 490 for driving the data electrodes X1 to Xm, a control board 420 for controlling the scan driver 450, the sustain driver 470 and the data driver 490, a power supply board (not shown) for supply power to each of the scan driver 450, the sustain driver 470 and the data driver 490, and a current communication unit 690 for electrically connecting the Z sustain boards 480a and 480b in order to communicate the current depending on driving differences between the Z sustain boards 480a and 480b.

The PDP 400 comprises the sustain electrodes Z1 to Zn commonly connected to the scan electrodes Y1 to Yn through the conductive connection pad 700, and the data electrodes X1 to Xm crossing the scan electrodes Y1 to Yn and the sustain electrodes Z1 to Zn. The size of the PDP 400 may be 70 inches or more.

The scan driver 450 comprises a plurality of scan driver boards 440a and 440b, and a plurality of Y sustain boards 460a and 460b. When the PDP 400 is driven, the scan driver boards 440a and 440b generate a reset pulse and a scan pulse in a reset period and an address period, and the Y sustain boards 460a and 460b generate a Y sustain pulse in a sustain period. The number of the scan driver boards 440a and 440b and the Y sustain boards 460a and 460b is proportional to the screen size of a PDP. The scan driver 450 comprising the plurality of scan driver boards 440a and 440b and the Y sustain boards 460a and 460b as described above supplies the scan pulse, generated from the scan driver boards 440a and 440b, to the scan electrodes Y1 to Yn of the PDP 400 via Y FPCs 510a and 510b, and supplies the Y sustain pulse, generated from the Y sustain boards 460a and 460b, to the scan electrodes Y1 to Ym via the scan driver boards 440a and 440b and the Y FPCs 510a and 510b.

The sustain driver 470 comprises two or more Z sustain boards 480a and 480b, and the current communication unit 690. The two or more Z sustain boards 480a and 480b supply a bias pulse to the sustain electrodes Z1 to Zn commonly connected through the conductive connection pad 700 during the address period and supply a Z sustain pulse to the sustain electrodes Z1 to Zn during the sustain period, when the PDP 400 is driven. The current communication unit 690 electrically connects the Z sustain boards 480a and 480b, and communicates the current depending on driving deviation between the Z sustain boards 480a and 480b.

The number of the Z sustain boards 480a and 480b is proportional to the screen size of the PDP 400. By doing so, the increased manufacturing cost due to the large size of the driving board which would otherwise be required in accordance with a large size of the PDP 400, can be avoided.

The current communication unit 690 communicates current, which is generated as the sustain electrodes Z1 to Zn commonly connected via the conductive connection pad 700 is driven, that is, current depending on driving differences between the Z sustain boards 480a and 480b, between the Z sustain boards 480a and 480b through the current communication unit 690 using the two or more Z sustain boards 480a and 480b. Accordingly, damage to the sustain electrodes Z1 to Zn near the conductive connection pad 700 can be prevented.

As illustrated in FIG. 8, a method can be used in which the sustain electrodes Z1 to Zn are divided into two or more electrode groups Y1 to Yn/2 and Yn/2+1 to Yn, and the electrode groups are connected through conductive connection pads 800a and 800b on an electrode-group basis in order to electrically separate the electrode groups on an electrode-group basis. The size of the PDP 400 may be 70 inches or more.

It is preferred, but not essential to the invention in its broadest aspect, that the current communication unit 690 have a resistance value smaller than that of the connection pad 700. A large amount of current is communicated through the current communication unit 690 depending on driving difference between the Z sustain boards 480a and 480b by employing a characteristic of current in inverse proportion to resistance value as described above. Therefore, damage to the sustain electrodes Z1 to Zn near the conductive connection pad 700 can be prevented.

The current communication unit 690 may for example be formed from any one of a PCB, a FPC and conductive metal material in consideration of the manufacturing cost and/or the easiness of manufacture. Other suitable materials known to the skilled person may be employed.

The current communication unit 690 may be constructed to electrically connect output terminals of the Z sustain boards 480a and 480b. In this case, current depending on driving difference between the Z sustain boards 480a and 480b can be communicated through the current communication unit 690 more efficiently. However this is not essential to the invention in its broadest aspect.

The data driver 490 comprises a data driver board 500 for generating the data pulse in the address period when the PDP 400 is driven. The data pulse is supplied to the data electrodes X1 to Xm of the PDP 400 via a X FPC 540.

The control board 420 generates X, Y and Z timing control signals of the scan driver 450, the sustain driver 470 and the data driver 490. The control board 420 supplies the Y timing control signal to the scan driver 450 via first FPCs 560a and 560b, the Z timing control signal to the sustain driver 470 via second FPCs 580a and 580b, and the X timing control signal to the data driver 490 via a third FPC 600.

The described embodiment of the plasma display apparatus can save the manufacturing cost associated with large sizes of PDP, prevent damage to the sustain electrodes, and provide stable driving.

Exemplary embodiments of the invention having been thus described, it will be obvious that the same may be varied in many ways. Such variations are not to be regarded as a departure from the scope of the invention, and all such modifications, including, but not limited to, the modifications specifically referred to, as would be obvious to one skilled in the art are intended to be included within the scope of the claims.

## Claims

1. A plasma display apparatus comprising:
a Plasma Display Panel (PDP) comprising sustain electrodes commonly connected through a conductive connection pad;
two or more Z sustain boards arranged to drive the sustain electrodes; and
a current communication unit arranged to electrically connect the Z sustain boards and to communicate current between the Z sustain boards.

2. A plasma display apparatus comprising:
a PDP comprising sustain electrodes divided into two or more electrode groups and connected through a conductive connection pad on a electrode-group basis;
Z sustain boards arranged to drive the respective electrode groups; and
a current communication unit arranged to electrically connect the Z sustain boards and to communicate current between the Z sustain boards.

3. The plasma display apparatus as claimed in claim 1 or 2, wherein the current communication unit comprises a deviation current communication unit for communicating current depending on driving differences between the Z sustain boards.

4. The plasma display apparatus as claimed in any preceding claim, wherein the current communication unit has a resistance value smaller than that of the connection pad.

5. The plasma display apparatus as claimed in any preceding claim, wherein the current communication unit comprises any one of a PCB, a FPC and conductive metal.

6. The plasma display apparatus as claimed in any preceding claim, wherein the current communication unit electrically connects output terminals of the Z sustain boards.

7. The plasma display apparatus as claimed in any preceding claim, wherein the PDP has a size of at least 70 inches.
